# EUROPEAN PATENT APPLICATION

(11) **EP 1 925 648 A2**
(43) Date of publication of application: **28.05.2008**
(21) Application number: 07254581.7
(22) Date of filing: 26.11.2007
(51) Int. Cl.: C09G 1/02, H01L 21/321

(54) **Polishing composition and polishing process**

(30) Priority: 27.11.2006 JP 2006318670
(71) Applicant: FUJIMI INCORPORATED, Aichi (JP)
(72) Inventor: Hattori, Masayuki, c/o Fujimi Incorporated, Kiyosu-shi Aichi (JP); Satoh, Hideyuki, c/o Fujimi Incorporated, Kiyosu-shi Aichi (JP); Kawamura, Atsunori, c/o Fujimi Incorporated, Kiyosu-shi Aichi (JP)
(74) Representative: Paget, Hugh Charles Edward

(57) **Abstract**

To provide a polishing composition which is suitable particularly for an application to polish a wafer containing tungsten, and a polishing process employing such a polishing composition.

The polishing composition of the present invention comprises a colloidal silica and hydrogen peroxide. The pH of the polishing composition is from 5 to 8.5, and the concentration of iron ions in the polishing composition is at most 0.02 ppm. The polishing composition preferably further contains phosphoric acid or a phosphate.

## Description

The present invention relates to a polishing composition which is used mainly for an application to polish a wafer containing tungsten, more specifically for an application to polish a wafer having a tungsten pattern to form tungsten plugs, and a polishing method employing such a polishing composition.

As a polishing composition which is used for an application to polish a wafer containing tungsten, a polishing composition comprising an oxidizing agent such as hydrogen peroxide, an iron catalyst such as iron nitrate and abrasive grains such as silica, is disclosed in Patent Document 1. However, when the polishing composition of such Patent Document 1 is used for polishing, there has been a problem that iron contamination of the wafer due to iron ions in the polishing composition is unavoidable. Further, by the polishing composition of Patent Document 1, it was not possible to selectively polish a tungsten film against a silicone oxide film.

Patent Document 1: JP-A-10-265766

The present invention has been made under such a circumstance, and it is an object of the present invention to provide a polishing composition which is more suitable for an application to polish a wafer containing tungsten, and a polishing method employing such a polishing composition.

In order to accomplish the above object, the present invention provides the following:
1. A polishing composition comprising a colloidal silica and hydrogen peroxide and having a pH of from 5 to 8.5 and a concentration of iron ions in the polishing composition being at most 0.02 ppm.
2. The polishing composition according to the above 1, which further contains phosphoric acid or a phosphate.
3. The polishing composition according to the above 1 or 2, whereby the ratio of the stock removal rate of a tungsten film to the stock removal rate of a silicon oxide film is at least 3.
4. The polishing composition according to any one of the above 1 to 3, which is capable of suppressing the fluctuation in loss of a silicon oxide film on a wafer after polishing with the polishing composition, to at most 20 nm.
5. A polishing method which comprises polishing a wafer containing tungsten by using the polishing composition as defined in any one of the above 1 to 4.

According to the present invention, a polishing composition which is more suitable for an application to polish a wafer containing tungsten, and a polishing method employing such a polishing composition, are presented.

Now, one embodiment of the present invention will be described.

The polishing composition of this embodiment is produced by mixing a colloidal silica and hydrogen peroxide, preferably together with a pH controlling agent, with water, so that the pH will be from 5 to 8.5, and the iron ion concentration in the polishing composition will be at most 0.02 ppm. Accordingly, the polishing composition comprises a colloidal silica, hydrogen peroxide and water, and preferably further contains a pH controlling agent.

This polishing composition is used for an application to polish a wafer containing tungsten. More specifically, it is used for an application to polish a wafer provided with a tungsten pattern to form tungsten plugs, particularly for an application to selectively polish a tungsten film against a silicon oxide film.

The above-mentioned colloidal silica has a function to selectively mechanically polish a tungsten film against a silicon oxide film in a pH range of from 5 to 8.5 and serves to improve the stock removal rate of a tungsten film by the polishing composition. Here, in a case where instead of the colloidal silica, other abrasive grains such as fumed silica or α-alumina are used, it is not possible to reduce the degree of erosion to a practically sufficient level, as measured on a wafer after polishing with the polishing composition.

The colloidal silica contained in the polishing composition is preferably a colloidal silica prepared by a sol-gel method rather than a colloidal silica prepared by a sodium silicate method. As compared with the colloidal silica prepared by a sodium silicate method, the colloidal silica prepared by a sol-gel method has a high purity and is advantageous in that impurity metal ions such as iron ions or sodium ions are little. The preparation of the colloidal silica by a sol-gel method is carried out by dissolving methyl silicate in a solvent comprising methanol, ammonia and water, followed by hydrolysis. On the other hand, the preparation of the colloidal silica by a sodium silicate method is carried out via ion exchange by using sodium silicate as a starting material.

The average primary particle size of the colloidal silica contained in the polishing composition is preferably at least 8 nm, more preferably at least 10 nm, further preferably at least 12 nm. As the average primary particle size increases, the function of the colloidal silica to mechanically polish a tungsten film increases, whereby the stock removal rate of a tungsten film by the polishing composition will be improved. In this respect, it is possible to improve the stock removal rate of a tungsten film by the polishing composition to a practically particularly suitable level, when the average primary particle size of the colloidal silica is at least 8 nm, more preferably at least 10 nm, further preferably at least 12 nm.

The average primary particle size of the colloidal silica contained in the polishing composition is preferably at most 100 nm, more preferably at most 85 nm, further preferably at most 70 nm. As the average primary particle size decreases, the dispersibility of the colloidal silica will be improved, whereby sedimentation of the colloidal silica in the polishing composition tends to less likely to occur. In this respect, it is possible to improve the dispersibility of the colloidal silica in the polishing composition to a practically particularly suitable level, when the average primary particle size of the colloidal silica is at most 100 nm, preferably at most 85 nm, further preferably at most 70 nm. Further, when the average primary particle size of the colloidal silica is at most 70 nm, it is possible to suppress the decrease in the stock removal rate of a tungsten film by the polishing composition which may take place when the average primary particle size is too large. Here, the value of the average primary particle size as described in the foregoing, is one calculated based on the specific surface area of the colloidal silica measured by BET method.

The content of the colloidal silica in the polishing composition is preferably at least 10 g/L, more preferably at least 15 g/L, further preferably at least 20 g/L. As the content of the colloidal silica increases, the stock removal rate of a tungsten film by the polishing composition will be improved. In this respect, it is possible to improve the stock removal rate of a tungsten film by the polishing composition to a practically particularly suitable level, when the content of the colloidal silica in the polishing composition is at least 10 g/L, preferably at least 15 g/L, further preferably at least 20 g/L.

The content of the colloidal silica in the polishing composition is at most 200 g/L, more preferably at most 150 g/L, further preferably at most 100 g/L. As the content of the colloidal silica decreases, the stock removal rate of a silicon oxide film by the polishing composition tends to decrease substantially as compared with the stock removal rate of a tungsten film, whereby the selectivity for polishing a tungsten film against a silicon oxide film will be improved. In this respect, it is possible to improve the selectivity for polishing a tungsten film against a silicon oxide film to a practically particularly suitable level, when the content of the colloidal silica in the polishing composition is at most 200 g/L, preferably at most 150 g/L, further preferably at most 100 g/L.

The above-mentioned hydrogen peroxide has a function to oxidize a tungsten film and serves to improve the stock removal rate of a tungsten film by the polishing composition.

Hydrogen peroxide contained in the polishing composition is preferably EL grade i.e. a high purity product for electronic industry.

The content of hydrogen peroxide in the polishing composition is preferably at least 10 g/L, more preferably at least 30 g/L, further preferably at least 50 g/L. As the content of hydrogen peroxide increases, the stock removal rate of a tungsten film by the polishing composition will be improved. In this respect, it is possible to improve the stock removal rate of a tungsten film by the polishing composition to a practically particularly suitable level, when the content of hydrogen peroxide in the polishing composition is at least 10 g/L, preferably at least 30 g/L, further preferably at least 50 g/L.

The content of hydrogen peroxide in the polishing composition is at most 200 g/L, more preferably at most 150 g/L, more preferably at most 100 g/L. As the content of hydrogen peroxide decreases, the material cost of the polishing composition can be suppressed. In this respect, when the content of hydrogen peroxide in the polishing composition is at most 200 g/L, preferably at most 150 g/L, more preferably at most 100 g/L, such is advantageous from the viewpoint of the cost versus the effect.

The above-mentioned pH controlling agent may suitably be incorporated, as the case requires, so that the pH of the polishing composition is brought to from 5 to 8.5, preferably from 6 to 8, more preferably from 6.5 to 7.5.

An acid to be used as the pH controlling agent may be an inorganic acid selected from nitric acid, hydrochloric acid, boric acid, sulfuric acid and phosphoric acid, or an organic acid selected from succinic acid, citric acid, malic acid, glyceric acid, mandelic acid, ascorbic acid, glutamic acid, glyoxylic acid, glycolic acid, lactic acid, gluconic acid, tartaric acid, maleic acid and itaconic acid. Among them, nitric acid is preferred with a view to improving the stability of the polishing composition, and phosphoric acid is preferred with a view to improving the stock removal rate of a tungsten film by the polishing composition, and citric acid is preferred with a view to stabilizing hydrogen peroxide in the polishing composition.

Further, the alkali to be used as a pH controlling agent is preferably ammonia, an ammonium salt other than a quaternary ammonium salt, or an alkali metal hydroxide, more preferably an alkali metal hydroxide other than sodium hydroxide, or ammonia, most preferably ammonia. In a case where ammonia, an ammonium salt other than a quaternary ammonium salt, or an alkali metal hydroxide, is used, a polishing composition having a good slurry stability can be obtained, as compared with a case where other alkali, particularly a quaternary ammonium salt, is used. Further, in a case where an alkali metal hydroxide other than sodium hydroxide, or ammonia is used, it is possible to avoid a trouble by diffusion of sodium ions in the silicon oxide film, and in a case where ammonia is used, it is possible to avoid a trouble by diffusion of alkali metal ions in the silicon oxide film. The alkali metal hydroxide other than sodium hydroxide is preferably potassium hydroxide, since it is readily available.

It is essential that the pH of the polishing composition is at least 5. Namely, when the pH of the polishing composition is at least 5, it is possible to improve the selectivity for polishing a tungsten film against a silicon oxide film, since polishing of a silicon oxide film by the polishing composition is suppressed. However, if the pH of the polishing composition is weakly acidic, the stability of the colloidal silica in the polishing composition tends to decrease. Accordingly, in order to improve the stability of the colloidal silica, the pH of the polishing composition is preferably at least 6, more preferably at least 6.5.

It is also essential that the pH of the polishing composition is at most 8.5. Namely, if the pH of the polishing composition exceeds 8.5, it becomes difficult to improve the stock removal rate of a tungsten film by the polishing composition to a practically sufficient level. In order to improve the stock removal rate of a tungsten film by the polishing composition to a practically particularly suitable level, the pH of the polishing composition is preferably at most 8, more preferably at most 7.5.

The following merits are obtainable according to this embodiment.

The polishing composition of this embodiment comprises a colloidal silica and hydrogen peroxide and has a pH set to be from 5 to 8.5, whereby it is possible to selectively polish a tungsten film against a silicon oxide film. Thus, according to this polishing composition, it is possible to minimize a loss of the silicon oxide film and to suppress a fluctuation in the loss of the silicon oxide film to a small level, whereby the surface planarization of the wafer after polishing will be improved. Further, the iron ion concentration in the polishing composition is at most 0.02 ppm, whereby iron contamination of the wafer can be extremely suppressed. Thus, the polishing composition of this embodiment is suitable for an application to polish a wafer containing tungsten, more specifically for an application to polish a wafer provided with a tungsten pattern to form tungsten plugs.

The polishing composition of this embodiment does not contain an iode compound such as an iodic acid or a periodic acid, whereby there will be no generation of iodine gas to corrode the polishing apparatus or polishing pad, from the polishing composition during polishing.

The above embodiment may be modified as follows.

In the polishing composition of the above embodiment, at least two types of colloidal silica, for example, at least two types of colloidal silica differing in the average primary particle size, may be incorporated.

In the polishing composition of the above embodiment, at least two types of pH controlling agents may be incorporated.

In the polishing composition of the above embodiment, a phosphate may be incorporated. In a case where a phosphate is incorporated, it is possible to improve the stock removal rate of a tungsten film by the polishing composition, like in a case where phosphoric acid is used as the pH controlling agent. The phosphate to be incorporated to the polishing composition may be an alkali metal phosphate, or an ammonium phosphate such as ammonium dihydrogenphosphate.

To the polishing composition of the above embodiment, a surfactant, a water-soluble polymer or a metal chelating agent may, for example, be added, as the case requires. The surfactant may be an anionic surfactant or a nonionic surfactant. The water-soluble polymer may, for example, be a polyacrylic acid, a hydroxyethylcellulose or pullulan. The metal chelating agent may, for example, be ethylenediamine tetraacetic acid or diethylenetriamine pentaacetic acid.

The polishing composition of the above embodiment may be one-pack type or multi-pack type such as two-pack type. In the case of a multi-pack type, the pH of the agent containing the colloidal silica is preferably from 6 to 12, more preferably from 6.5 to 11. If this pH is too low, the dispersion stability of the colloidal silica tends to be poor, and gelation is likely to occur. On the other hand, if the pH is too high, dissolution of the colloidal silica is likely to occur.

The polishing composition of the above embodiment may be prepared by diluting a stock solution of the polishing composition with water.

The polishing composition of the above embodiment may be used also for an application to polish a wafer provided with a tungsten pattern to form tungsten wirings.

Now, Examples of the present invention and Comparative Examples will be described.

### EXAMPLES 1 to 16 and COMPARATIVE EXAMPLES 1 to 13

Polishing compositions of Examples 1 to 16 were prepared by suitably mixing a colloidal silica, hydrogen peroxide, an acid, an alkali and a phosphate with water. Polishing compositions of Comparative Examples 1 to 13 were prepared by suitably mixing a colloidal silica or abrasive grains as a substitute therefor, hydrogen peroxide or an oxidizing agent as a substitute therefor, an acid, an alkali and a phosphate or a salt as a substitute therefor, with water. The details of the colloidal silica or the abrasive grains as a substitute therefor, the hydrogen oxide or the oxidizing agent as a substitute therefor, the acid, the alkali and the phosphate or the salt as a substitute therefor in the polishing compositions of the respective Examples, as well as the pH of the polishing compositions and the results of measurement of the iron ion concentrations in the polishing compositions, are shown in Table 1. Further, for the measurement of the iron ion concentrations in the polishing compositions, a plasma emission spectrometric apparatus "ICPS-8100" manufactured by Shimadzu Corporation, was used.

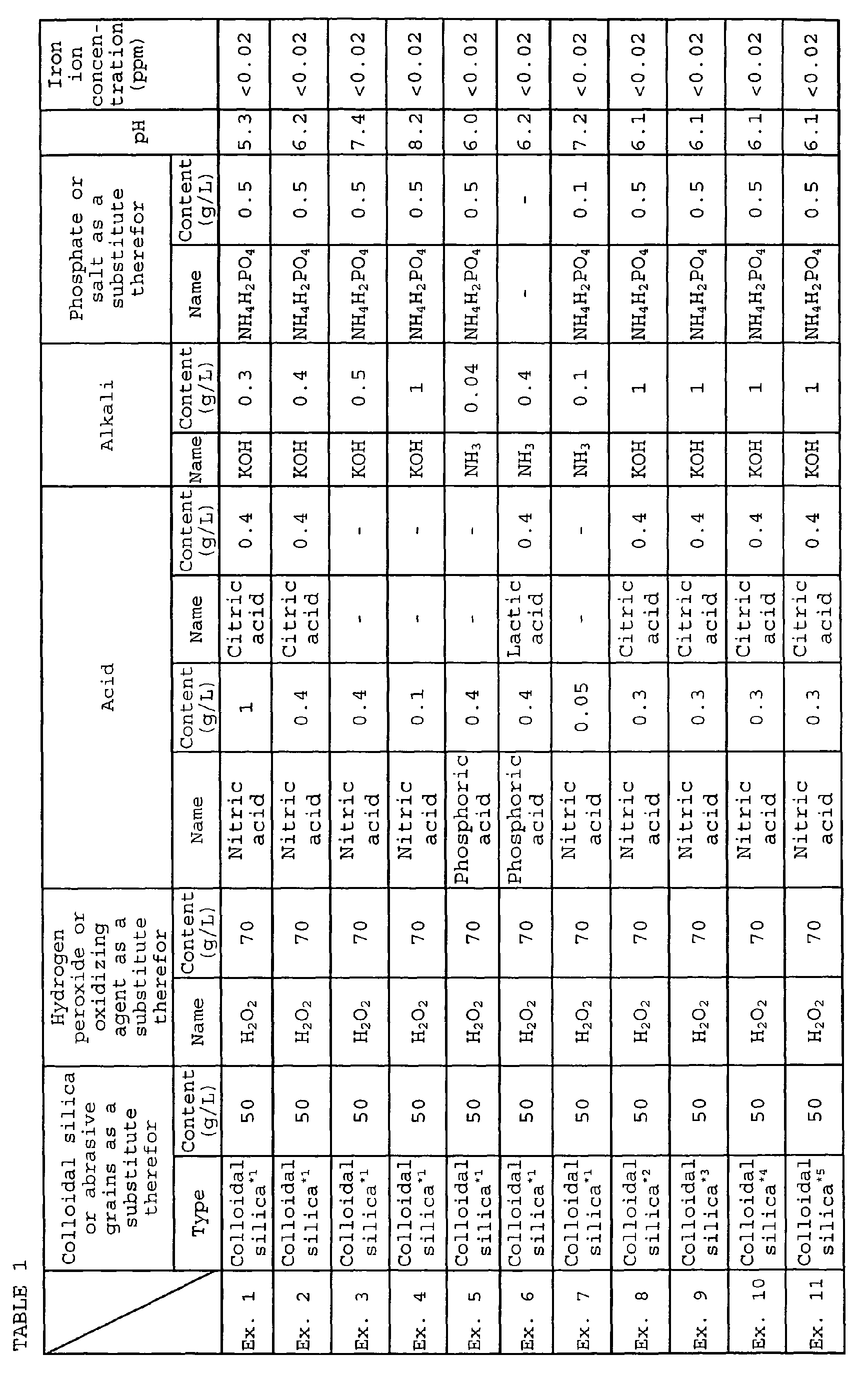

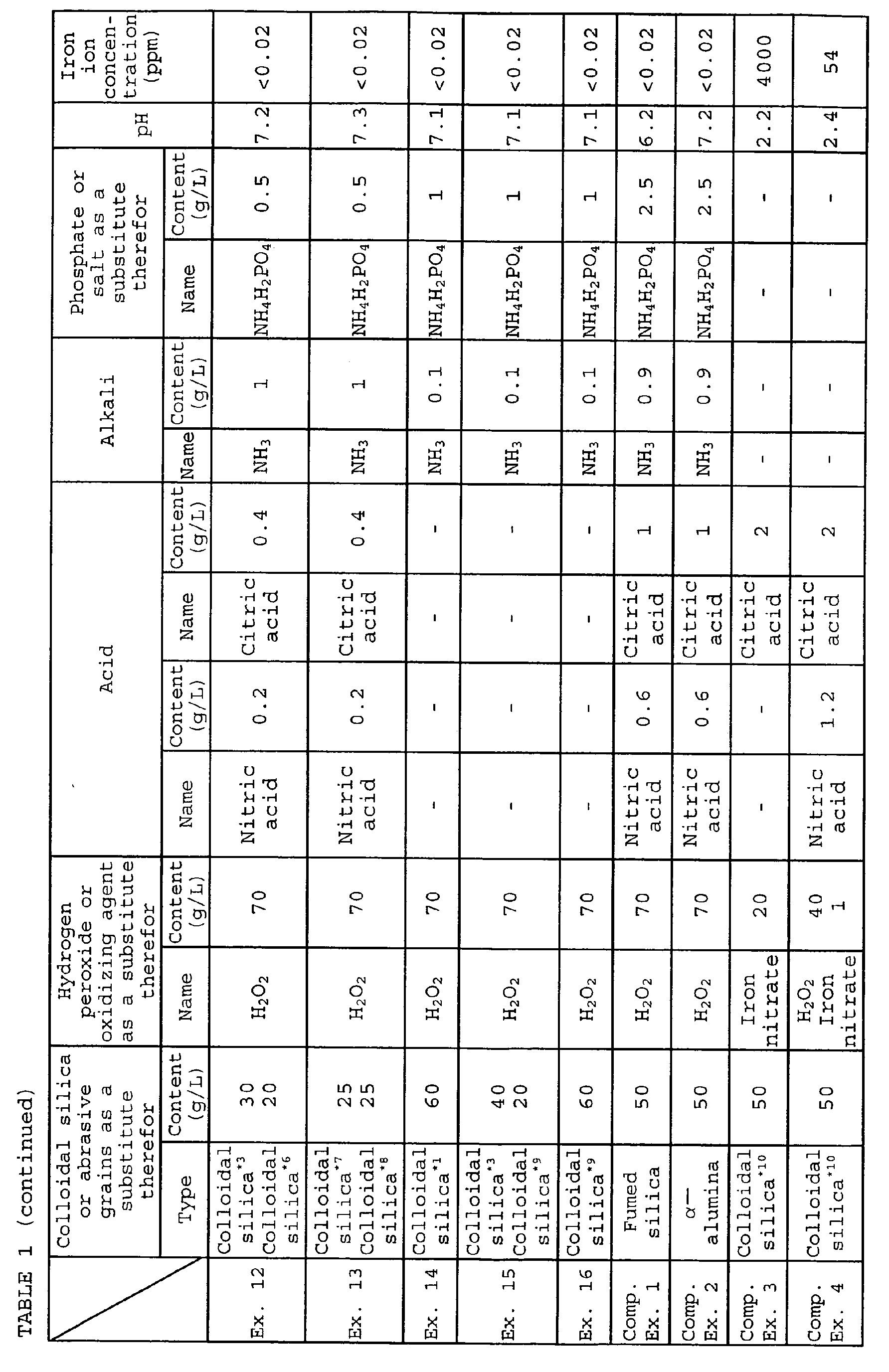

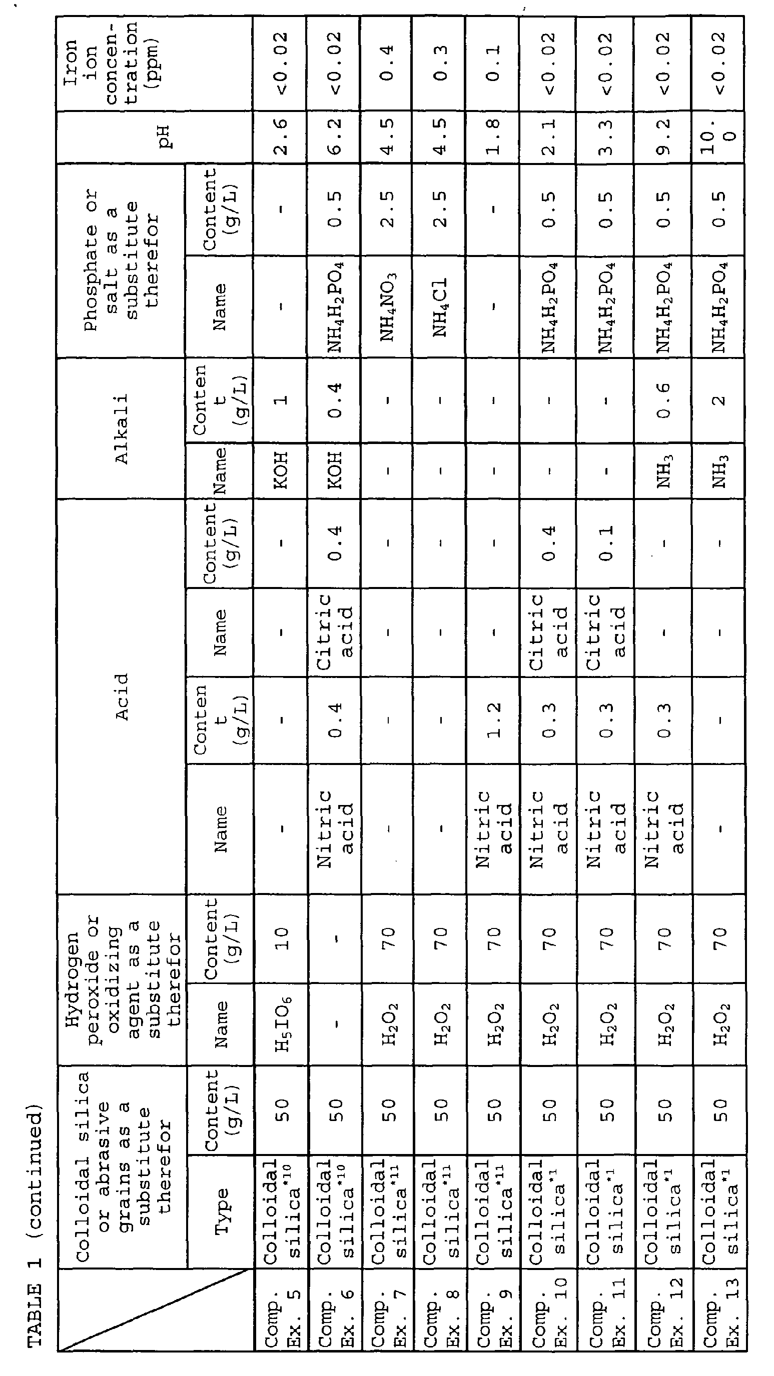

In the column for "Colloidal silica or abrasive grains as a substitute therefor" in Table 1, "Colloidal silica^{*1}" represents a colloidal silica having an average primary particle size of 28 nm by a sol-gel method; "Colloidal silica^{*2}" represents a colloidal silica having an average primary particle size of 23 nm by a sol-gel method; "Colloidal silica^{*3}" represents a colloidal silica having an average primary particle size of 36 nm by a sol-gel method; "Colloidal silica^{*4}" represents a colloidal silica having an average primary particle size of 44 nm by a sol-gel method; "Colloidal silica^{*5}" represents a colloidal silica having an average primary particle size of 67 nm by a sol-gel method; "Colloidal silica^{*6}" represents a colloidal silica having an average primary particle size of 22 nm by a sol-gel method; "Colloidal silica^{*7}" represents a colloidal silica having an average primary particle size of 90 nm by a sol-gel method; "Colloidal silica^{*8}" represents a colloidal silica having an average primary particle size of 11 nm by a sol-gel method; "Colloidal silica^{*9}" represents a colloidal silica having an average primary particle size of 10 nm by a sol-gel method; "Colloidal silica^{*10}" represents a colloidal silica having an average primary particle size of 30 nm by a sol-gel method, "Colloidal silica^{*11}" represents a colloidal silica having an average primary particle size of 30 nm by a sodium silicate method, "Fumed silica" represents a fumed silica having an average particle size of 30 nm; and "α-alumina" represents an α-alumina having an average particle size of 190 nm.

In the column for "oxidizing agent" in Table 1, "H₂O₂" represents hydrogen peroxide; and "H₅IO₆" represents orthoperiodic acid.

In the column for "Alkali" in Table 1, "KOH" represents potassium hydroxide, and "NH₃" represents ammonia.

In the column "salt" in Table 1, "NN₄H₂PO₄" represents ammonium dihydrogenphosphate; "NH₄NO₃" represents ammonium nitrate; and "NH₄Cl" represents ammonium chloride.

In the columns for "Stock removal rate of tungsten film" and "Stock removal rate of silicon oxide film" in the following Table 2, the results of measurements of the stock removal rate of a tungsten film and the stock removal rate of a silicon oxide film (TEOS film) are shown when a tungsten blanket wafer and a TEOS blanket wafer were polished under the polishing conditions shown in Table 3, by using the polishing compositions of the respective Examples. The stock removal rate was obtained by dividing the difference in thickness of each wafer between before and after the polishing, by the polishing time. For the measurement of the thickness of the tungsten blanket wafer, a sheet resistance measuring device "VR-120" manufactured by Kokusai Denki System Service K.K. was used, and for the measurement of the thickness of the TEOS blanket wafer, a film thickness-measuring device "ASET F5x" manufactured by KLA Tencor, was used.

In the column for "Selectivity" in Table 2, the results of calculation of the ratio of the stock removal rate of a tungsten film to the stock removal rate of a silicon oxide film from the stock removal rates of the tungsten film and the silicon oxide film obtained as described above, are shown.

In the column "Erosion" in Table 2, the results of measurement of the degree of erosion of a tungsten pattern-formed wafer (manufactured by Advantec Co., Ltd.) polished under the polishing conditions shown in Table 3 by using the polishing compositions of the respective Examples, are shown. In the tungsten pattern-formed wafer used, a TEOS film having a thickness of 40 nm, a titanium film having a thickness of 20 nm, a titanium nitride film having a thickness of 50 nm and a tungsten film having a thickness of 400 nm were formed in this order from the bottom. Tungsten plugs with a width of 0.2 µm were formed at intervals of 0.2 µm on the wafer by polishing the tungsten pattern-formed wafer until the polished amount of the TEOS film reached 80 nm. The measurement of the degree of erosion was carried out by means of Profiler "HRP340" which is a contact type surface measuring device manufactured by KLA Tencor.

In the column for "Iron contamination" in Table 2, the results of evaluation of the degree of iron contamination of a tungsten pattern-formed wafer after polishing under the polishing conditions shown in Table 3 by using the polishing compositions of the respective Examples. Specifically, by using a total reflection fluorescent X-ray analyzer "TREX620" manufactured by TECHNOS JAPAN CORP., the number of iron atoms on the surface of the tungsten pattern-formed wafer after polishing was counted, whereby a case where the number is less than 1×10¹⁰ (atoms/cm²) was evaluated to be O (good), and a case where the number is at least 1×10¹⁰ (atoms/cm²) was evaluated to be × (no good).

In the column for "Slurry stability" in Table 2, the results of evaluation of the slurry stability of the polishing composition of each Example are shown. More specifically, 1 liter of the polishing composition of each Example was put into a polyethylene bottle having a capacity of 1 liter and held in a constant temperature tank of 80°C, and upon expiration of one day, a case where sedimentation was observed in the polishing composition or gelation of the polishing composition occurred, was evaluated to be × (no good), a case where no sedimentation or gelation was observed upon expiration of one day, but sedimentation or gelation was observed upon expiration of one week was evaluated to be Δ (acceptable), and a case where no sedimentation or gelation was observed even upon expiration of one week was evaluated to be ○ (good).

In the column for "Iodine gas" in Table 2, the results of evaluation of the iodine gas concentration in the polishing composition in each Example are shown. Specifically, by using an iodine gas concentration detector "EC-777" manufactured by Riken Keiki co., Ltd., the iodine gas concentration of the polishing composition in each Example was measured, whereby a case where the iodine gas concentration is at most 0.1 ppm, was evaluated to be O (good), and a case where the concentration exceeds 0.1 ppm was evaluated to be × (no good).

**TABLE 2**

| | Stock removal rate of tungsten film (nm/min) | Stock removal rate of silicon oxide film (nm/min) | Selectivity | Erosion (nm) | Iron contamination | Fluctuation in loss of silicon oxide film (nm) | Slurry stability | Iodine gas |
|---|---|---|---|---|---|---|---|---|
| Example 1 | 240 | 51 | 4.7 | 26 | ○ | 13 | Δ | ○ |
| Example 2 | 225 | 21 | 10.7 | 22 | ○ | 10 | Δ | ○ |
| Example 3 | 228 | 15 | 15.2 | 26 | ○ | 9 | ○ | ○ |
| Example 4 | 180 | 22 | 8.2 | 29 | ○ | 8 | ○ | ○ |
| Example 5 | 234 | 23 | 10.2 | 12 | ○ | 9 | Δ | ○ |
| Example 6 | 224 | 15 | 14.9 | 28 | ○ | 2 | Δ | ○ |
| Example 7 | 205 | 11 | 18.6 | 21 | ○ | 3 | ○ | ○ |
| Example 8 | 238 | 15 | 15.9 | 28 | ○ | 3 | Δ | ○ |
| Example 9 | 240 | 15 | 16.0 | 28 | ○ | 3 | Δ | ○ |
| Example 10 | 220 | 12 | 18.3 | 18 | ○ | 3 | Δ | ○ |
| Example 11 | 240 | 15 | 16.0 | 28 | ○ | 2 | Δ | ○ |
| Example 12 | 226 | 14 | 16.1 | 15 | ○ | 1 | ○ | ○ |
| Example 13 | 221 | 17 | 13.0 | 15 | ○ | 2 | ○ | ○ |
| Example 14 | 228 | 19 | 12.0 | 22 | ○ | 4 | ○ | ○ |
| Example 15 | 221 | 11 | 20.1 | 15 | ○ | 2 | ○ | ○ |
| Example 16 | 210 | 9 | 23.3 | 15 | ○ | 1 | ○ | ○ |
| Comparative Example 1 | 184 | 22 | 8.4 | 150 | ○ | 15 | Δ | ○ |
| Comparative Example 2 | 183 | 19 | 9.6 | 130 | ○ | 2 | ○ | ○ |
| Comparative Example 3 | 320 | 210 | 1.5 | 98 | × | 31 | ○ | ○ |
| Comparative Example 4 | 390 | 210 | 1.9 | 11 | × | 25 | ○ | ○ |
| Comparative Example 5 | 230 | 110 | 2.1 | 45 | ○ | 32 | Δ | × |
| Comparative Example 6 | 19 | 21 | 0.9 | 22 | ○ | - | Δ | ○ |
| Comparative Example 7 | 71 | 102 | 0.7 | 68 | × | 42 | × | ○ |
| Comparative Example 8 | 64 | 192 | 0.3 | 72 | × | 41 | × | ○ |
| Comparative Example 9 | 98 | 260 | 0.4 | 81 | × | 31 | ○ | ○ |
| Comparative Example 10 | 210 | 290 | 0.7 | 12 | ○ | 55 | ○ | ○ |
| Comparative Example 11 | 204 | 234 | 0.9 | 23 | ○ | 29 | Δ | ○ |
| Comparative Example 12 | 91 | 125 | 0.7 | 21 | ○ | 31 | ○ | ○ |
| Comparative Example 13 | 45 | 104 | 0.4 | 33 | ○ | 29 | ○ | ○ |

**TABLE 3**

| Polishing machine: One-side CMP polishing machine Mirra (manufactured by Applied Materials) |
|---|
| Polishing pad: Polyurethane laminated pad IC-1000/SubalV (manufactured Rohm and Haas Company) |
| Polishing pressure: 6 psi (about 42 kPa) |
| Plate rotational speed: 117 rpm |
| Carrier rotational speed: 123 rpm |
| Supply rate of polishing composition: 125 mL/min |

As shown in Table 2, by the polishing compositions of Examples 1 to 16, with respect to the stock removal rate of a tungsten film, values of practically sufficient level being at least 100 nm/min, were obtained. Also with respect to the selectivity between the silicon oxide film and the tungsten film, values of practically sufficient level being at least 3, were obtained. Further, by the polishing compositions of Examples 1 to 16, also with respect to the erosion, values of practically sufficient level being at most 40 nm, were obtained. Further, also with respect to the fluctuation in loss of a silicon oxide film, values of practically sufficient level being at most 20 nm, were obtained. Further, by the polishing compositions of Examples 1 to 16, evaluation relating to iron contamination was good in each case.

Whereas, by the polishing compositions of Comparative Examples 1 to 13, values of practically sufficient level were not obtained with respect to the selectivity between the silicon oxide film and the tungsten film. Further, by the polishing compositions of Comparative Examples 1 and 2, values of practically sufficient level were not obtained with respect to the erosion.

The entire disclosure of Japanese Patent Application No. 2006-318670 filed on November 27, 2006 including specification, claims and summary is incorporated herein by reference in its entirety.

## Claims

1. A polishing composition comprising a colloidal silica and hydrogen peroxide and having a pH of from 5 to 8.5 and a concentration of iron ions in the polishing composition being at most 0.02 ppm.

2. The polishing composition according to Claim 1, which further contains phosphoric acid or a phosphate.

3. The polishing composition according to Claim 1 or 2, whereby the ratio of the stock removal rate of a tungsten film to the stock removal rate of a silicon oxide film is at least 3.

4. The polishing composition according to any one of Claims 1 to 3, which is capable of suppressing the fluctuation in loss of a silicon oxide film on a wafer after polishing with the polishing composition, to at most 20 nm.

5. A polishing method which comprises polishing a wafer containing tungsten by using the polishing composition as defined in any one of Claims 1 to 4.
